# FASCICULE DE BREVET EUROPEEN

(11) **EP 3 613 080 B1**
(45) Date de publication et mention de la délivrance du brevet: **09.03.2022**
(21) Numéro de dépôt: 18723573.4
(22) Date de dépôt: 19.04.2018
(51) Int. Cl.: H01L 27/30

(54) **DISPOSITIF DE DETECTION D'UN RAYONNEMENT COMPRENANT DES PHOTODIODES ORGANIQUES**
STRAHLUNGSDETEKTIONSVORRICHTUNG, ORGANISCHE FOTODIODEN UMFASSEND
RADIATION DETECTION DEVICE COMPRISING ORGANIC PHOTODIODES

(30) Priorité: 20.04.2017 FR 1753424
(43) Date de publication de la demande: 26.02.2020
(73) Titulaire: ISORG, 87068 Limoges Cedex 3 (FR)
(72) Inventeur: BAILLY, Adrien, 38000 Grenoble (FR); SARACCO, Emeline, 38000 Grenoble (FR); BOUTHINON, Benjamin, 38000 Grenoble (FR); HINGANT, Franck, 38000 GRENOBLE (FR)
(74) Mandataire: Cabinet Beaumont
(86) Numéro de dépôt international: PCT/FR2018/050982
(87) Numéro de publication internationale: WO 2018/193216

(56) Documents cités:
- DE-A1-102012 220 056
- JP-A- 2004 022 908
- US-A1- 2013 070 131

## Description

la demande de brevet français FR17/53424.

### Domaine

La présente demande concerne un dispositif de détection d'un rayonnement électromagnétique, notamment la lumière, comprenant une matrice de photodiodes organiques.

### Exposé de l'art antérieur

On a déjà proposé de réaliser des dispositifs de détection d'un rayonnement électromagnétique comprenant des transistors et des photodiodes à base de matériaux conducteurs et semiconducteurs organiques. Ces matériaux présentent l'avantage d'être plus faciles à déposer et moins fragiles que les matériaux conducteurs et semiconducteurs inorganiques utilisés de façon classique pour la fabrication de circuits intégrés, par exemple le silicium.

L'utilisation de matériaux organiques permet, en outre, de façon avantageuse, de réaliser le dispositif de détection sur tous types de support et, en particulier, sur des supports souples tels que du plastique, du papier, du carton ou du tissu, sur des supports de grandes dimensions, par exemple des panneaux publicitaires, ou sur des supports jetables tels que des emballages de produits de consommation courante.

Le dispositif de détection peut comprendre une matrice de photodétecteurs disposés en rangées et en colonnes. Chaque photodétecteur peut comprendre une photodiode organique montée en série avec un composant électronique permettant de sélectionner la photodiode associée lors de la commande du dispositif de détection. Les éléments de sélection peuvent être des transistors organiques (en anglais Organic Thin Film Transistor ou OTFT).

US 2013/070131 A1 décrit un dispositif de détection d'un rayonnement électromagnétique comprenant une photodiode et une zone de stockage de charges. DE 10 2012 220056 A1 et JP 2004 022908 A divulguent des dispositifs de détection d'un rayonnement électromagnétique comprenant au moins un photodétecteur comprenant une diode organique électroluminescente et au moins une photodiode organique.

Un inconvénient est que le procédé de fabrication du dispositif de détection peut alors comprendre un nombre important d'étapes, notamment les étapes de fabrication des photodiodes organiques et les étapes de fabrication des transistors organiques.

### Résumé

Un objet d'un mode de réalisation est de pallier tout ou partie des inconvénients des dispositifs de détection de rayonnement électromagnétique à photodiodes organiques décrits précédemment.

Un autre objet d'un mode de réalisation est de réduire le nombre d'étapes du procédé de fabrication du dispositif de détection.

Ainsi, un mode de réalisation prévoit un dispositif de détection d'un rayonnement électromagnétique comprenant au moins un photodétecteur comprenant une diode organique,différente d'une diode électroluminescente, et une photodiode organique formées dans un même empilement de couches semiconductrices, la photodiode organique recevant ledit rayonnement, le photodétecteur comprenant, en outre, au moins un écran opaque audit rayonnement et occultant la partie de l'empilement correspondant à la diode.

Selon un mode de réalisation, l'anode de la diode est connectée à l'anode de la photodiode ou la cathode de la diode est connectée à la cathode de la photodiode.

Selon un mode de réalisation, le dispositif comprend un support, une première portion conductrice s'étendant sur le support et une deuxième portion conductrice s'étendant sur le support, l'empilement recouvrant au moins partiellement la première portion conductrice et au moins partiellement la deuxième portion conductrice, la distance minimale entre la première portion conductrice et la deuxième portion conductrice étant supérieure à 10 nm.

Selon un mode de réalisation, l'écran opaque est situé du côté du support opposé aux première et deuxième portions conductrices.

Selon un mode de réalisation, la première portion conductrice est au moins partiellement transparente au rayonnement et la deuxième portion conductrice est opaque au rayonnement.

Selon un mode de réalisation, le dispositif comprend, en outre, une couche isolante recouvrant l'empilement, l'écran opaque étant situé sur la couche isolante, du côté de la couche isolante opposé à l'empilement.

Selon un mode de réalisation, le dispositif comprend, en outre, un élément conducteur s'étendant sur la couche isolante et au travers de la couche isolante, l'élément conducteur étant au contact de la première portion conductrice ou de la deuxième portion conductrice, l'élément conducteur formant, en outre, l'écran opaque.

Selon un mode de réalisation, le dispositif comprend une matrice de photodétecteurs répartis en rangées et en colonnes.

Selon un mode de réalisation, l'empilement comprend au moins des première, deuxième et troisième couches semiconductrices, la deuxième couche semiconductrice étant interposée entre la première couche semiconductrice et la troisième couche semiconductrice et étant au contact de la première couche semiconductrice et de la troisième couche semiconductrice, la deuxième couche semiconductrice étant la couche où est capturée la majorité du rayonnement reçu par la photodiode.

Selon un mode de réalisation, la première couche semiconductrice est au contact de la première portion conductrice et de la deuxième portion conductrice.

Selon un mode de réalisation, la première couche semiconductrice et/ou la troisième couche semiconductrice est en un matériau choisi parmi le groupe comprenant :
un oxyde métallique, notamment un oxyde de titane ou un oxyde de zinc ;
un système hôte/dopant moléculaire, notamment les produits commercialisés par la société Novaled sous les appellations NET-5/NDN-1 ou NET-8/MDN-26 ;
un polymère conducteur ou semiconducteur dopé, par exemple le polymère PEDOT:Tosylate qui est un mélange de poly(3,4)-éthylènedioxythiophène et de tosylate ;
un carbonate, par exemple du CsCO3 ;
un polyélectrolyte, par exemple du poly[9,9-bis(3'-(N,N-diméthylamino)propyl)-2,7-fluorène-alt-2,7-(9,9-dioctyfluorène)] (PFN), du poly[3-(6- trimethylammoniumhexyl] thiophene (P3TMAHT) ou du poly[9,9-bis(2-ethylhexyl) fluorene]-b-poly[3-(6- trimethylammoniumhexyl] thiophene (PF2/6-b-P3TMAHT) ;
un polymère de polyéthylèneimine (PEI) ou un polymère de polyéthylèneimine éthoxylée (PEIE), propoxylée et/ou butoxylée ; et
un mélange de deux ou de plus de deux de ces matériaux. Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un dispositif de détection d'un rayonnement électromagnétique comprenant une matrice de photodétecteurs organiques ;
les figures 2 et 3 sont respectivement une vue de dessus et une vue en coupe, partielles et schématiques, d'un mode de réalisation d'un photodétecteur du dispositif de détection de la figure 1 ;
les figures 4, 5 et 6 sont respectivement une vue de dessus et deux vues en coupe, partielles et schématiques, d'un autre mode de réalisation d'un photodétecteur du dispositif de détection de la figure 1 ;
les figures 7A à 7E sont des vues en coupe, partielles et schématiques, de structures obtenues à des étapes successives d'un mode de réalisation d'un procédé de fabrication du photodétecteur représenté sur les figures 2 et 3 ; et
les figures 8 à 13 sont des vues en coupe analogues à la figure 3 d'autres modes de réalisation d'un photodétecteur du dispositif de détection de la figure 1.

### Description détaillée

Par souci de clarté, de mêmes éléments ont été désignés par de mêmes références aux différentes figures et, de plus, les diverses figures ne sont pas tracées à l'échelle. En outre, seuls les éléments utiles à la compréhension des modes de réalisation ont été représentés et sont décrits. En particulier, les moyens de traitement des signaux fournis par le dispositif de détection décrit ci-après sont à la portée de l'homme de l'art et ne sont pas décrits. Dans la suite de la description, sauf indication contraire, les termes "sensiblement", "environ" et "de l'ordre de" signifient "à 10 % près". Dans la suite de la description, un composé électronique est dit "organique" lorsqu'au moins la majorité des matériaux qui le composent sont organiques. Dans la suite de la description, on appelle "couche active" d'une photodiode la couche de la photodiode dans laquelle se produit la majorité de la conversion du rayonnement électromagnétique reçu par la photodiode en un signal électrique.

Un mode de réalisation prévoit un dispositif de détection d'un rayonnement électromagnétique, notamment dans une plage de longueurs d'onde comprises entre 400 nm et 1000 nm, comprenant une matrice de photodétecteurs organiques dans lequel chaque photodétecteur comprend une photodiode organique et un élément de sélection correspondant à une diode organique, différente d'une diode électroluminescente, l'anode de la diode étant connectée à l'anode de la photodiode ou la cathode de la diode étant connectée à la cathode de la photodiode. La photodiode et la diode sont formées par un empilement de couches organiques semiconductrices qui sont communes pour la diode et la photodiode. Un écran opaque empêche que le rayonnement reçu par le photodétecteur n'atteigne une partie de l'empilement. La partie de l'empilement qui n'est pas éclairée fonctionne comme une diode et la partie de l'empilement qui est éclairée fonctionne comme une photodiode. L'empilement recouvre deux portions conductrices qui sont espacées suffisamment pour imposer un sens privilégié de circulation des charges dans l'empilement. La couche de l'empilement à l'extrémité de l'empilement opposée aux portions conductrices forme l'électrode commune entre la diode et la photodiode.

La structure du dispositif de détection est plus simple que celle d'un dispositif de détection comprenant une matrice de photodiodes organiques et de transistors de sélection. Le procédé de fabrication du dispositif de détection est, en outre, simplifié. En effet, les étapes de formation de la photodiode et de la diode de sélection sont confondues.

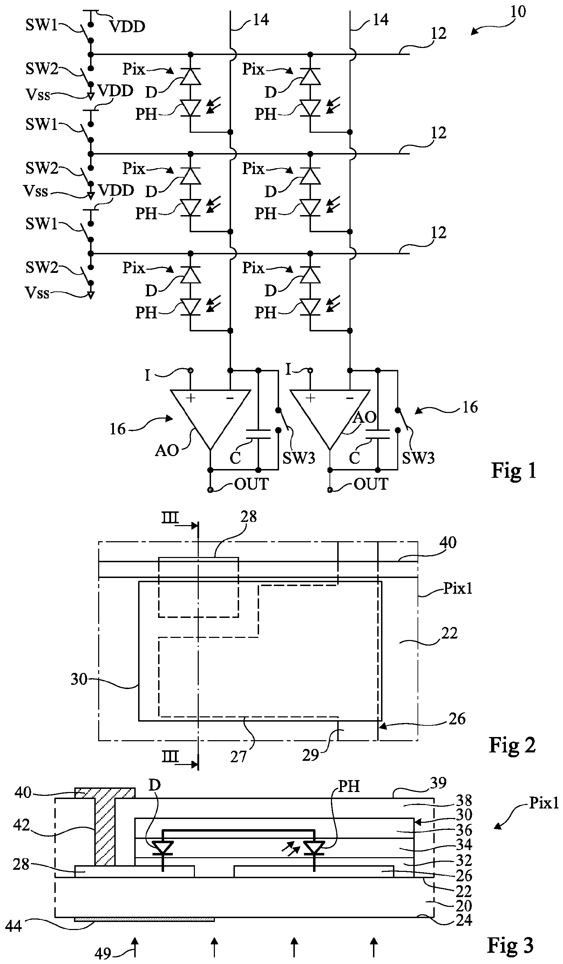

La figure 1 est un schéma électrique d'un mode de réalisation d'un dispositif 10 de détection d'un rayonnement électromagnétique, par exemple de la lumière, comprenant une matrice de photodétecteurs Pix répartis en rangées et en colonnes. En figure 1, trois rangées et deux colonnes sont représentées à titre d'exemple. Chaque photodétecteur Pix comprend une photodiode PH et une diode D de sélection montées en série. Dans le présent mode de réalisation, l'anode de la diode D est connectée à l'anode de la photodiode PH associée. La cathode de la diode D est connectée à une piste conductrice 12 qui s'étend selon la rangée associée au photodétecteur Pix et la cathode de la photodiode PH est connectée à une piste conductrice 14 qui s'étend selon la colonne associée au photodétecteur Pix.

Chaque piste conductrice 12 peut être reliée, par un interrupteur SW1, à une source d'un potentiel de référence haut VDD, qui peut être compris entre 1 V et 10 V, ou, par un interrupteur SW2, à une source d'un potentiel de référence bas Vss, qui peut être compris entre 0 V et -10 V, par exemple la masse. Dans la suite de la description, on considère que le potentiel de référence bas est égal à 0 V et que le potentiel de référence haut est égal à VDD, par exemple sensiblement 5 V. Les interrupteurs SW1 et SW2 sont commandés par un module de commande non représenté. Chaque piste conductrice 14 est reliée à un circuit de lecture 16. Selon un mode de réalisation, chaque circuit de lecture 16 comprend un amplificateur opérationnel AO monté en intégrateur. L'entrée inverseuse (-) de l'amplificateur opérationnel AO est reliée à la piste conductrice 14. L'entrée non inverseuse (+) de l'amplificateur opérationnel AO est reliée à un noeud I maintenu, en fonctionnement, à un potentiel intermédiaire entre le potentiel de référence haut et le potentiel de référence bas, par exemple à VDD/2. La sortie OUT de l'amplificateur opérationnel AO est reliée à l'entrée inverseuse (-) de l'amplificateur opérationnel AO par un condensateur C. Un interrupteur SW3 est monté en parallèle aux bornes du condensateur C et permet, lorsqu'il est fermé, de décharger le condensateur C.

Le fonctionnement du dispositif de détection 10 est le suivant. La sélection des photodiodes PH est réalisée rangée par rangée. Pour chaque rangée qui n'est pas sélectionnée, la piste conductrice 12 de la rangée est maintenue sensiblement à VDD. Comme le potentiel à l'entrée inverseuse (-) de chaque comparateur AO est à VDD/2, chaque diode D de la rangée non sélectionnée est polarisée en inverse tandis que chaque photodiode PH de la rangée non sélectionnée est polarisée en direct. Le courant circulant dans le photodétecteur correspond alors au courant en inverse, ou courant d'obscurité, de la diode D qui est très faible, par exemple inférieur à 10⁻¹⁰ A. La sélection des photodiodes PH d'une rangée est obtenue en reliant la piste conductrice 12 de la rangée sélectionnée à la masse GND. Chaque diode D de la rangée sélectionnée est alors polarisée en direct tandis que chaque photodiode PH de la rangée sélectionnée est polarisée en inverse. Le courant circulant dans le photodétecteur correspond au courant en inverse de la photodiode PH et dépend du rayonnement reçu par la photodiode PH. Le courant circulant sur chaque piste 14 est égal à la somme du courant fourni par le photodétecteur Pix de la rangée sélectionnée et des courants d'obscurité des diodes D des autres rangées non sélectionnées.

La figure 2 est une vue de dessus, partielle et schématique, d'un mode de réalisation d'un photodétecteur Pix1 pouvant correspondre à l'un des photodétecteurs Pix du dispositif de détection 10. La figure 3 est une coupe de la figure 2 selon la ligne III-III. En figure 2, on a représenté en traits pointillés le contour d'une portion conductrice ou semiconductrice recouverte, en vue de dessus, par une autre portion conductrice ou semiconductrice.

Le photodétecteur Pix1 comprend :
un support 20 comprenant deux faces 22, 24 opposées ;
des première et deuxième portions 26, 28 conductrices électriquement, disjointes et s'étendant sur la face 22, la première portion conductrice 26 comprenant une partie 27 formant une électrode de la photodiode PH et une partie 29 formant la piste conductrice 14 ;
un empilement 30 de couches semiconductrices comprenant une première couche d'interface 32 recouvrant une partie de la première portion conductrice 26, une partie de la deuxième portion conductrice 28 et une partie du support 20 entre les portions conductrices 26, 28, une couche active 34 recouvrant la couche d'interface 32 et une deuxième couche d'interface 36 recouvrant la couche active 34 ;
une couche 38 isolante électriquement comprenant une face 39 opposée au support 20 et recouvrant la couche d'interface 36, les parties des portions conductrices 26, 28 non recouvertes par l'empilement 30 et les parties du support 20 non recouvertes par l'empilement 30 et les portions conductrices 26, 28 ;
un élément 40 conducteur électriquement s'étendant sur la face 39 de la couche isolante 38 pour former la piste conductrice 12 et se prolongeant, en outre, dans une ouverture 42 traversant la couche isolante 38 pour venir au contact de la deuxième portion conductrice 28 ; et
une région 44, opaque au rayonnement détecté par le dispositif 10, et recouvrant la face 24 du support 20 en regard d'une partie de l'empilement 30.

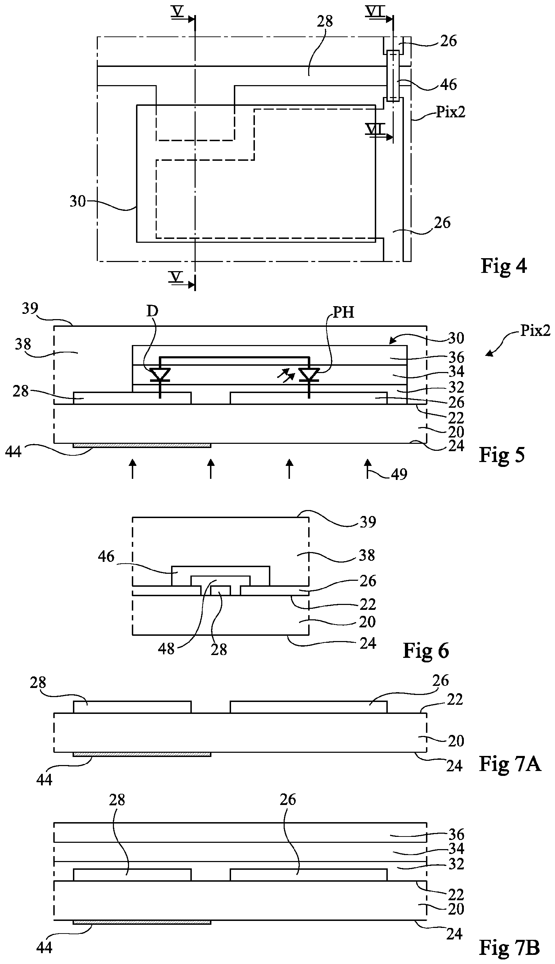

La figure 4 est une vue de dessus, partielle et schématique, d'un autre mode de réalisation d'un photodétecteur Pix2 pouvant correspondre à l'un des photodétecteurs Pix du dispositif de détection 10. La figure 5 est une coupe de la figure 4 selon la ligne V-V et la figure 6 est une coupe de la figure 4 selon la ligne VI-VI. En figure 4, on a représenté en traits pointillés le contour d'une portion conductrice ou semiconductrice recouverte, en vue de dessus, par une autre portion conductrice ou semiconductrice.

Le photodétecteur Pix2 représenté aux figures 4 à 6 comprend l'ensemble des éléments du photodétecteur Pix1 représenté sur les figures 2 et 3 à la différence que l'élément conducteur 40 n'est pas présent et que la piste conductrice 12 est réalisée par la portion conductrice 28. Le croisement entre les portions conductrices 26 et 28 est réalisé en interrompant la portion conductrice 26 et en prévoyant un pont conducteur 46 qui relie les deux parties séparées de la portion conductrice 26 et qui enjambe la portion conductrice 28. Le pont conducteur 46 est isolé électriquement de la portion conductrice 28 par une région isolante 48.

Selon une variante du photodétecteur Pix2, la couche d'interface 32 et la couche active 34 peuvent, de façon avantageuse, s'étendre sur la totalité de la surface du photodétecteur Pix2.

Le support 20 peut être en un matériau diélectrique. Le support 20 peut être un support rigide, par exemple en verre. Le support 20 peut être un support flexible, par exemple en un polymère ou en un matériau métallique. Des exemples de polymère sont le polyéthylène naphtalène (PEN), le polyéthylène téréphtalate (PET), le kapton, et le polyétheréthercétone (PEEK). L'épaisseur du support 20 est, par exemple, comprise entre 20 µm et 1 cm, par exemple environ 125 µm. Le support 20 peut être en un matériau transparent ou translucide, par exemple en verre ou en plastique, notamment dans le cas où le dispositif 10 est destiné à recevoir un éclairement du côté de la face 24.

Les portions conductrices 26 et 28 peuvent être en un matériau conducteur et transparent, par exemple en oxyde conducteur et transparent ou TCO (acronyme anglais pour Transparent Conductive Oxide), en nanotubes de carbone, en graphène, en un polymère conducteur, en un métal, ou en un mélange ou un alliage d'au moins deux de ces composés. Les portions conductrices 26 et 28 peuvent avoir une structure multicouche.

Des exemples de TCO adaptés à la réalisation des portions conductrices 26 et 28 sont l'oxyde d'indium-étain (ITO, de l'anglais Indium Tin Oxide), l'oxyde d'aluminium-zinc (AZO, de l'anglais Aluminium Zinc Oxide) et l'oxyde de gallium-zinc (GZO, de l'anglais Gallium Zinc Oxide). Des exemples de polymères conducteurs adaptés à la réalisation des portions conductrices 26 et 28 sont le polymère connu sous la dénomination PEDOT:PSS, qui est un mélange de poly(3,4)-éthylènedioxythiophène et de polystyrène sulfonate de sodium, et la polyaniline, également appelé PAni. Des exemples de métaux adaptés à la réalisation des portions conductrices 26 et 28 sont l'argent (Ag), l'aluminium (Al), l'or (Au), le cuivre (Cu), le nickel (Ni), le titane (Ti) et le chrome (Cr). Un exemple de structure multicouche adaptée à la réalisation des portions conductrices 26 et 28 est une structure multicouche d'AZO et d'argent de type AZO/Ag/AZO.

L'épaisseur des portions conductrices 26 et 28 peut être comprise entre 5 nm et 30 µm, par exemple de l'ordre de 150 nm. Dans le cas où les portions conductrices 26, 28 sont métalliques et doivent être au moins partiellement transparentes, l'épaisseur des portions conductrices 26, 28 est inférieure ou égale à 20 nm, de préférence inférieure ou égale à 10 nm. L'écart minimum entre la portion conductrice 26 et la portion conductrice 28 du photodétecteur Pix1, Pix2 est supérieur ou égal à 10 nm, de préférence supérieur ou égal à 1 µm, plus préférentiellement compris entre 10 µm et 500 µm.

La couche d'interface 32 ou 36 peut correspondre à une couche injectrice d'électrons ou à une couche injectrice de trous suivant selon que cette couche d'interface joue le rôle d'une cathode ou d'une anode. Le travail de sortie de la couche d'interface 32 ou 36 est adapté à bloquer, collecter ou injecter des trous et/ou des électrons suivant que cette couche d'interface joue le rôle d'une cathode ou d'une anode. Plus précisément, lorsque la couche d'interface 32 ou 36 joue le rôle d'anode, elle correspond à une couche injectrice de trous et bloqueuse d'électrons. Le travail de sortie de la couche d'interface 32 ou 36 est alors supérieur ou égal à 4,5 eV, de préférence supérieur ou égal à 5 eV. Lorsque la couche d'interface 32 ou 36 joue le rôle de cathode, elle correspond à une couche injectrice d'électrons et bloqueuse de trous. Le travail de sortie de la couche d'interface 32 ou 36 est alors inférieur ou égal à 5 eV, de préférence inférieur ou égal à 4,2 eV.

Dans le cas où la couche d'interface 32 ou 36 joue le rôle d'une couche injectrice d'électrons, le matériau composant la couche d'interface 32 ou 36 est choisi parmi le groupe comprenant :
un oxyde métallique, notamment un oxyde de titane ou un oxyde de zinc ;
un système hôte/dopant moléculaire, notamment les produits commercialisés par la société Novaled sous les appellations NET-5/NDN-1 ou NET-8/MDN-26 ;
un polymère conducteur ou semiconducteur dopé, par exemple le polymère PEDOT:Tosylate qui est un mélange de poly(3,4)-éthylènedioxythiophène et de tosylate ;
un carbonate, par exemple du CsCO3 ;
un polyélectrolyte, par exemple du poly[9,9-bis(3'-(N,N-diméthylamino)propyl)-2,7-fluorène-alt-2,7-(9,9-dioctyfluorène)] (PFN), du poly[3-(6- trimethylammoniumhexyl] thiophene (P3TMAHT) ou du poly[9,9-bis(2-ethylhexyl) fluorene]-b-poly[3-(6- trimethylammoniumhexyl] thiophene (PF2/6-b-P3TMAHT) ;
un polymère de polyéthylèneimine (PEI) ou un polymère de polymère de polyéthylèneimine éthoxylée (PEIE), propoxylée et/ou butoxylée ; et
un mélange de deux ou de plus de deux de ces matériaux.

De préférence, la première couche d'interface 32 joue le rôle d'une couche injectrice d'électrons et est en polymère de polyéthylèneimine éthoxylée. L'épaisseur de la couche d'interface 32 est de préférence comprise entre 0,1 nm et 500 nm. De préférence, la couche d'interface 32 a une résistance électrique supérieure à 10⁹ Ω/□, de préférence supérieure ou égale à 10¹² Ω/□. La résistance électrique élevée de la couche d'interface 32 permet d'éviter la formation d'un court-circuit avec les portions conductrices 26, 28.

Dans le cas où la couche d'interface 32 ou 36 joue le rôle d'une couche injectrice de trous, le matériau composant la couche d'interface 32 ou 36 peut être choisi parmi le groupe comprenant :
un polymère conducteur ou semiconducteur dopé, notamment les matériaux commercialisés sous les appellations Plexcore OC RG-1100, Plexcore OC RG-1200 par la société Sigma-Aldrich, le polymère PEDOT:PSS ou une polyaniline ;
un système hôte/dopant moléculaire, notamment les produits commercialisés par la société Novaled sous les appellations NHT-5/NDP-2 ou NHT-18/NDP-9 ;
un polyélectrolyte, par exemple le Nafion ;
un oxyde métallique, par exemple un oxyde de molybdène, un oxyde de vanadium, de l'ITO, ou un oxyde de nickel ; et
un mélange de deux ou de plus de deux de ces matériaux.

De préférence, dans le cas où la couche d'interface 32 ou 36 joue le rôle d'une couche injectrice de trous, le matériau composant la couche d'interface 32 ou 36 est un polymère conducteur ou semiconducteur dopé.

De préférence, la deuxième couche d'interface 36 joue le rôle de couche injectrice de trous et est en PEDOT:PSS. Un avantage du PEDOT:PSS est qu'il peut être facilement déposé par des techniques d'impression, par exemple par jet d'encre, par héliographie, par sérigraphie, par revêtement par filière (en anglais slot-die coating) ou par enduction. La couche d'interface 36 fournit un chemin conducteur entre la diode D et la photodiode PH. L'épaisseur de la couche d'interface 36 est de préférence comprise entre 10 nm et 50 µm. De préférence, la couche d'interface 36 a une résistance électrique inférieure à 10kΩ/□, de préférence inférieure ou égale à 1kΩ/□. La résistance électrique faible de la couche d'interface 36 permet de réduire le temps de réponse et d'améliorer la linéarité du dispositif.

La couche active 34 peut comprendre des petites molécules, des oligomères ou des polymères. Il peut s'agir de matériaux organiques ou inorganiques. La couche active 34 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la couche active 34 peut être comprise entre 50 nm et 1 µm, par exemple de l'ordre de 300 nm.

Des exemples de polymères semiconducteurs de type P adaptés à la réalisation de la couche active 34 sont le poly(3-hexylthiophène) (P3HT), le poly[N-9'-heptadécanyl-2,7-carbazole-alt-5,5-(4,7-di-2-thiényl-2',1',3'-benzothiadiazole] (PCDTBT), le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C), le poly[2-méthoxy-5-(2-éthyl-hexyloxy)-1,4-phénylène-vinylène] (MEH-PPV) ou le poly[2,6-(4,4-bis-(2-éthylhexyl)-4H-cyclopenta [2,1-b;3,4-b']dithiophène)-alt-4,7(2,1,3-benzothiadiazole)] (PCPDTBT).

Des exemples de matériaux semiconducteurs de type N adaptés à la réalisation de la couche active 34 sont les fullerènes, notamment le C60, le [6,6]-phényl-C₆₁-butanoate de méthyle ([60]PCBM), le [6,6]-phényl-C₇₁-butanoate de méthyle ([70]PCBM), le pérylène diimide, l'oxyde de zinc (ZnO) ou des nanocristaux permettant la formation de boîtes quantiques (en anglais quantum dots).

La couche isolante 38 peut avoir une épaisseur comprise entre 500 nm et 100 µm, par exemple environ 2 µm. La couche isolante 38 peut avoir une structure monocouche ou une structure multicouche. La couche isolante 38 peut être réalisée en polymère fluoré, notamment le polymère fluoré commercialisé sous l'appellation Cytop par la société Bellex, en polyvinylpyrrolidone (PVP), en polyméthacrylate de méthyle (PMMA), en polystyrène (PS), en parylène, en polyimide (PI) ou en un mélange d'au moins deux de ces composés. La couche 38 peut être déposée sous la forme d'une solution.

La région opaque 44 peut être en une encre à base de carbone, en graphène, en un métal, ou en un mélange ou un alliage d'au moins deux de ces composés. La région opaque 44 peut avoir une épaisseur comprise entre 10 nm et 100 µm, par exemple d'environ 10 µm.

Le pont conducteur 46 peut être réalisé en matériau conducteur, par exemple en PEDOT:PSS, en une encre argent ou en une encre carbonée. L'épaisseur du pont conducteur 46 peut être comprise entre 10 nm et 50 µm.

La région isolante 48 peut être réalisée en matériau diélectrique déposé en solution. L'épaisseur de la région isolante 48 peut être comprise entre 100 nm et 100 µm.

Dans le cas où le photodétecteur Pix1, Pix2 est destiné à recevoir un éclairement du côté de la face 24, comme c'est le cas des modes de réalisation représentés sur les figures 2 à 6, le support 20, les portions conductrices 26 et la première couche d'interface 32 sont au moins en partie transparents au rayonnement électromagnétique détecté par le dispositif de détection. Sur les figures 3 et 5, on a représenté schématiquement un rayonnement atteignant le photodétecteur Pix du côté de la face 24 par des flèches 49. La deuxième couche d'interface 36 et/ou la couche isolante 38 peuvent alors être au moins en partie opaques au rayonnement de façon à réduire les risques d'illumination indésirable de la couche active 34 par la face 39. Dans le cas où le photodétecteur Pix1, Pix2 est destiné à recevoir un éclairement du côté de la face 39 de la couche isolante 38, comme cela est le cas de modes de réalisation décrits par la suite, la couche isolante 38 et la deuxième couche d'interface 36 sont en des matériaux au moins en partie transparents. Le support 20, les portions conductrices 26, 28 et/ou la première couche d'interface 32 peuvent alors être au moins en partie opaques au rayonnement de façon à réduire les risques d'illumination indésirable de la couche active 34 par la face 24. Dans le cas où le photodétecteur Pix1, Pix2 est destiné à recevoir un éclairement indifféremment du côté de la face 24 ou du côté de la face 39, le support 20, les portions conductrices 26, 28 et la couche isolante 38 sont en des matériaux au moins en partie transparents.

De plus, dans le cas où le photodétecteur Pix1, Pix2 est destiné à recevoir un éclairement du côté de la face 39 de la couche isolante 38 et dans le cas où le support 20 est, en outre, au moins en partie transparent au rayonnement reçu par le photodétecteur, les portions conductrices 26, 28 peuvent être au moins en partie opaques au rayonnement de façon à réduire la propagation de la lumière dans le support 20 jusqu'à la diode D.

En fonctionnement, la région opaque 44 empêche que le rayonnement n'atteigne une partie de l'empilement 30 qui fonctionne alors comme une diode tandis que le reste de l'empilement 30, qui reçoit le rayonnement, fonctionne comme une photodiode PH. Le matériau composant la couche d'interface 36 est choisi avec une résistivité adaptée pour que sensiblement la totalité des charges circulent entre les portions conductrices 26 et 28 en traversant deux fois la couche active 34 de l'empilement 30, une fois dans la partie de l'empilement 30 occultée par la région opaque 44 et une fois dans la partie de l'empilement 30 recevant le rayonnement électromagnétique. On obtient bien ainsi une connexion entre la photodiode PH et la diode D à anode commune ou à cathode commune. Sur les figures 3 et 5, les symboles électriques de la diode D et de la photodiode PH ont été ajoutés.

Les figures 7A à 7E illustrent des étapes d'un mode de réalisation d'un procédé de fabrication du photodétecteur Pix1.

La figure 7A représente la structure obtenue après avoir formé les portions conductrices 26 et 28 sur la face 22 du support 20 et la région opaque 44 sur la face 24 du support 20.

Selon le matériau utilisé, le procédé de formation des portions conductrices 26, 28 et de la région opaque 44 peut correspondre à un procédé dit additif, par exemple par dépôt direct du matériau composant les portions conductrices 26, 28 ou la région opaque 44 aux emplacements souhaités. Le dépôt peut être réalisé par impression par jet d'encre, héliographie, sérigraphie, flexographie, revêtement par pulvérisation (en anglais spray coating) ou dépôt de gouttes (en anglais drop-casting). Le procédé de formation des portions conductrices 26, 28 et/ou de la région opaque 44 peut correspondre à un procédé dit soustractif, dans lequel une couche du matériau composant les portions conductrices 26, 28 et/ou de la région opaque 44 est déposée sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, par trempage, héliographie, revêtement par filière (en anglais slot-die coating), revêtement à la lame (en anglais blade-coating), flexographie ou sérigraphie. Lorsque les portions conductrices 26, 28 et/ou la région opaque 44 sont métalliques, le métal est, par exemple, déposé par évaporation ou par pulvérisation cathodique sur l'ensemble du support 20 et les portions conductrices 26, 28 et/ou la région opaque 44 sont délimitées par gravure. Lorsque les matériaux composant les portions conductrices 26, 28 sont différents, notamment lorsque les portions conductrices 26 sont opaques, les portions conductrices 26, 28 peuvent être formées à des étapes distinctes.

La figure 7B représente la structure obtenue après avoir déposé successivement les couches 32, 34, 36 sur la totalité du support 20. Les couches 34 et 36 peuvent être réalisées par revêtement par filière. La couche 32 peut être réalisée en plongeant la structure dans un bain du matériau composant la couche considérée, après avoir retiré la structure du bain et après avoir fait sécher la structure. Une étape de recuit peut être prévue après le dépôt de chaque couche 32, 34, 36 ou après le dépôt de certaines des couches 32, 34, 36, notamment la couche 32. Un traitement de surface peut être prévu après le dépôt de chaque couche 32, 34, 36 ou après le dépôt de certaines des couches 32, 34, 36, notamment la couche 34, pour améliorer le dépôt de la couche suivante. A titre d'exemple, le traitement de surface peut comprendre une étape de nettoyage au plasma, par exemple un plasma d'oxygène obtenu par une source plasma à couplage inductif comprenant un générateur de puissance radiofréquences dont la puissance peut être de 500 W, dans un réacteur à une pression de l'ordre de 133 Pa (environ 1 Torr) pendant 1 minute.

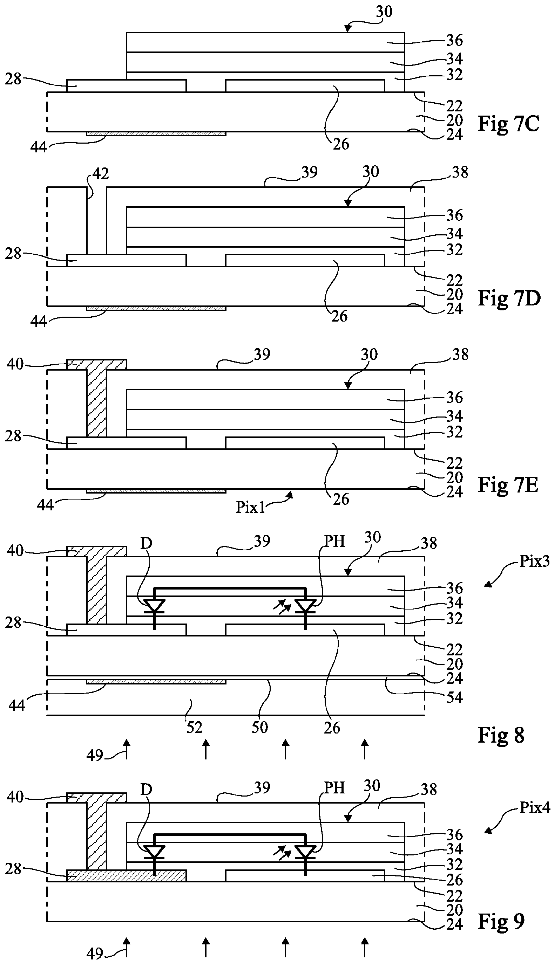

La figure 7C représente la structure obtenue après avoir gravé les couches 32, 34 et 36 pour délimiter l'empilement 30. La gravure peut être une gravure ionique réactive (RIE, acronyme anglais pour Reactive Ion Etching). Selon une variante, l'empilement 30 peut être formé par les procédés de dépôt additifs ou les autres procédés de dépôt soustractifs décrits précédemment.

La figure 7D représente la structure obtenue après une étape de dépôt de la couche isolante 38 sur la totalité de la structure et une étape de formation de l'ouverture 42 dans la couche isolante 38 pour chaque photodétecteur Pix1. La couche isolante 38 peut être déposée selon les procédés de dépôt additifs décrits précédemment. L'ouverture 42 peut être réalisée par RIE.

La figure 7E représente la structure obtenue après la formation de l'élément conducteur 40. L'élément conducteur 40 peut être déposé selon les procédés de dépôt additifs ou soustractifs décrits précédemment.

Les étapes suivantes du procédé de fabrication comprennent notamment l'encapsulation des photodétecteurs Pix1, par exemple en recouvrant les faces 24 et 39 de la structure représentée en figure 7E d'une couche de protection, et éventuellement la découpe du support 20 pour délimiter le dispositif de détection 10.

De façon avantageuse, le dispositif de détection 10 peut être réalisé par des techniques d'impression. Les matériaux des portions conductrices 26, 28, des couches 32, 34, 36, de l'élément conducteur 40 et/ou de la région opaque 44 peuvent être déposés sous forme liquide, par exemple sous forme d'encres conductrices et semiconductrices. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150°C, et le dépôt et les éventuels recuits peuvent être réalisés à la pression atmosphérique.

Dans le mode de réalisation décrit précédemment, l'occultation de la diode D par rapport au rayonnement reçu par le dispositif de détection est obtenue par la formation de la région opaque 44 sur la face 24 du support 22. Les figures 8 et 9 représentent d'autres modes de réalisation de l'occultation de la diode D adaptés à des photodétecteurs destinés à recevoir un rayonnement lumineux du côté de la face 24 du support 20.

La figure 8 représente un autre mode de réalisation d'un photodétecteur Pix3. Le photodétecteur Pix3 comprend l'ensemble des éléments du photodétecteur Pix1 à la différence que la région opaque 44 n'est pas formée sur la face 24 du support 20 mais est prévue sur une face 50 d'un revêtement 52 fixé à la face 24. Le revêtement 52 comprend une couche au moins en partie transparente au rayonnement détecté par la photodiode PH, par exemple une couche de PET ayant une épaisseur de 125 µm. Le revêtement 52 peut être fixé au support 20 par laminage, une couche de colle 54 pouvant être interposée entre la couche 52 et la face 24.

La figure 9 représente un autre mode de réalisation d'un photodétecteur Pix4. Le photodétecteur Pix4 comprend l'ensemble des éléments du photodétecteur Pix1 à la différence que la région opaque 44 n'est pas présente. L'occultation de la diode D est réalisée par la portion conductrice 28 qui est sensiblement opaque au rayonnement détecté par la photodiode PH alors que la portion conductrice 26 est au moins partiellement transparente à ce rayonnement. Selon un mode de réalisation, la portion conductrice 28 est en un matériau différent de la portion conductrice 26. A titre d'exemple, la portion conductrice 28 opaque est en matériaux métalliques ou correspond à un dépôt de type graphène ou graphite et la portion conductrice 26 transparente est en TCO, en nanofils d'Ag, ou en nanotubes de carbone. Le présent mode de réalisation permet, de façon avantageuse, de rapprocher l'écran d'occultation de la diode D.

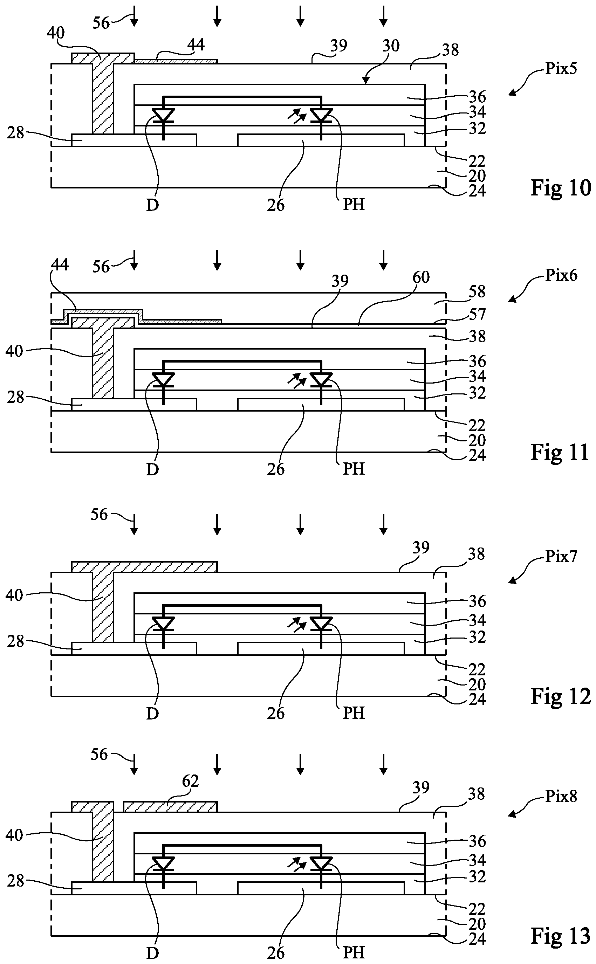

Les modes de réalisation représentés sur les figures 10 à 13 sont adaptés à des photodétecteurs destinés à recevoir un rayonnement lumineux du côté de la face 39 de la couche isolante 38. Sur ces figures, on a schématiquement représenté par des flèches 56 un rayonnement atteignant le photodétecteur du côté de la face 39 de la couche isolante 38.

La figure 10 représente un autre mode de réalisation d'un photodétecteur Pix5. Le photodétecteur Pix5 comprend l'ensemble des éléments du photodétecteur Pix1 à la différence que la région opaque 44 n'est pas formée sur la face 24 du support 20 mais est prévue sur la face 39 de la couche isolante 38.

La figure 11 représente un autre mode de réalisation d'un photodétecteur Pix6. Le photodétecteur Pix6 comprend l'ensemble des éléments du photodétecteur Pix5 à la différence que la région opaque 44 n'est pas formée sur la face 39 de la couche isolante 38 mais est prévue sur une face 57 d'un revêtement 58 fixé à la face 39 de la couche isolante 38. Le revêtement 58 comprend une couche isolante et au moins en partie transparente au rayonnement détecté par la photodiode PH, par exemple une couche de PET ayant une épaisseur de 125 µm. Le revêtement 58 peut être fixé à la couche isolante 38 par laminage, une couche de colle 60 pouvant être interposée entre le revêtement 58 et la couche isolante 38.

La figure 12 représente un autre mode de réalisation d'un photodétecteur Pix7. Le photodétecteur Pix7 comprend l'ensemble des éléments du photodétecteur Pix5 à la différence que la fonction d'occultation réalisée par la région opaque 44 pour le photodétecteur Pix5 est réalisée directement par l'élément conducteur 40 dont la partie qui s'étend sur la face 39 de la couche isolante 38 a une forme adaptée pour empêcher que le rayonnement 56 reçu par le photodétecteur Pix7 n'atteigne la diode D. Le procédé de fabrication du photodétecteur Pix7 comprend, de façon avantageuse, un nombre réduit d'étapes.

La figure 13 représente un autre mode de réalisation d'un photodétecteur Pix8. Le photodétecteur Pix8 comprend l'ensemble des éléments du photodétecteur Pix7 à la différence que la fonction d'occultation est réalisée par une région conductrice 62, située sur la face 39 de la couche isolante 38, qui est composée du même matériau que l'élément conducteur 40 et est réalisée simultanément à l'élément conducteur 40 mais qui n'est pas connecté électriquement à l'élément conducteur 40. Le présent mode de réalisation permet, de façon avantageuse, d'éviter que la région opaque 62 ne dégrade les propriétés de conduction de l'élément conducteur 40, notamment par l'injection de bruit, lors du fonctionnement du dispositif de détection 10.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, les modes de réalisation décrits précédemment en relation avec les figures 8 à 11 peuvent être mis en oeuvre avec le photodétecteur Pix2 décrit précédemment en relation avec les figures 4 à 6. De plus, dans le cas d'un dispositif de détection susceptible d'être exposé à un rayonnement à la fois du côté de la face 24 du support 20 et du côté de la face 39 de la couche isolante 38, un premier écran opaque empêchant l'exposition de la diode D de chaque photodétecteur à un rayonnement peut être prévu du côté de la face 24 selon l'un des modes de réalisation décrits précédemment et représentés sur les figures 2, 8 ou 9 et un deuxième écran opaque empêchant l'exposition de la diode D de chaque photodétecteur à un rayonnement peut être prévu du côté de la face 39 selon l'un des modes de réalisation décrits précédemment et représentés sur les figures 10 à 13.

## Revendications

1. Dispositif de détection (10) d'un rayonnement électromagnétique (49 ; 56) comprenant au moins un photodétecteur (Pix ; Pix1) comprenant une diode organique (D), différente d'une diode électroluminescente, et une photodiode organique (PH) formées dans un même empilement (30) de couches semiconductrices (32, 34, 36), la photodiode organique recevant ledit rayonnement, le photodétecteur comprenant, en outre, au moins un écran (44) opaque audit rayonnement et occultant la partie de l'empilement correspondant à la diode.

2. Dispositif de détection selon la revendication 1, dans lequel l'anode de la diode (D) est connectée à l'anode de la photodiode (PH) ou la cathode de la diode est connectée à la cathode de la photodiode.

3. Dispositif de détection selon la revendication 1 ou 2, comprenant un support (20), une première portion conductrice (26) s'étendant sur le support et une deuxième portion conductrice (28) s'étendant sur le support, l'empilement (30) recouvrant au moins partiellement la première portion conductrice et au moins partiellement la deuxième portion conductrice, la distance minimale entre la première portion conductrice et la deuxième portion conductrice étant supérieure à 10 nm.

4. Dispositif de détection selon la revendication 3, dans lequel l'écran opaque (44) est situé du côté du support (20) opposé aux première et deuxième portions conductrices (26, 28).

5. Dispositif de détection selon la revendication 3, dans lequel la première portion conductrice (26) est au moins partiellement transparente au rayonnement et la deuxième portion conductrice (28) est opaque au rayonnement.

6. Dispositif de détection selon la revendication 3, comprenant, en outre, une couche isolante (38) recouvrant l'empilement (30), l'écran opaque (44) étant situé sur la couche isolante, du côté de la couche isolante opposé à l'empilement.

7. Dispositif de détection selon la revendication 6, comprenant, en outre, un élément conducteur (40) s'étendant sur la couche isolante (38) et au travers de la couche isolante, l'élément conducteur (40) étant au contact de la première portion conductrice (26) ou de la deuxième portion conductrice (28), l'élément conducteur (40) formant, en outre, l'écran opaque.

8. Dispositif de détection selon l'une quelconque des revendications 1 à 7, comprenant une matrice de photodétecteurs (Pix) répartis en rangées et en colonnes.

9. Dispositif de détection selon l'une quelconque des revendications 1 à 8, dans lequel l'empilement (30) comprend au moins des première, deuxième et troisième couches semiconductrices, la deuxième couche semiconductrice (34) étant interposée entre la première couche semiconductrice (32) et la troisième couche semiconductrice (36) et étant au contact de la première couche semiconductrice et de la troisième couche semiconductrice, la deuxième couche semiconductrice étant la couche où est capturée la majorité du rayonnement reçu par la photodiode (PH).

10. Dispositif de détection selon la revendication 9 dans son rattachement à la revendication 3, dans lequel la première couche semiconductrice (32) est au contact de la première portion conductrice (26) et de la deuxième portion conductrice (28) .

11. Dispositif de détection selon la revendication 9 ou 10, dans lequel la première couche semiconductrice (32) et/ou la troisième couche semiconductrice (36) est en un matériau choisi parmi le groupe comprenant :
un oxyde métallique, notamment un oxyde de titane ou un oxyde de zinc ;
un système hôte/dopant moléculaire;
un polymère conducteur ou semiconducteur dopé, par exemple le polymère PEDOT:Tosylate qui est un mélange de poly(3,4)-éthylènedioxythiophène et de tosylate ;
un carbonate, par exemple du CsCO3 ;
un polyélectrolyte, par exemple du poly[9,9-bis(3'-(N,N-diméthylamino)propyl)-2,7-fluorène-alt-2,7-(9,9-dioctyfluorène)] (PFN), du poly[3-(6- trimethylammoniumhexyl] thiophene (P3TMAHT) ou du poly[9,9-bis(2-ethylhexyl) fluorene]-b-poly[3-(6- trimethylammoniumhexyl] thiophene (PF2/6-b-P3TMAHT) ;
un polymère de polyéthylèneimine (PEI) ou un polymère de polymère de polyéthylèneimine éthoxylée (PEIE), propoxylée et/ou butoxylée ; et
un mélange de deux ou de plus de deux de ces matériaux.

## Patentansprüche

1. Eine Vorrichtung (10) zum Detektieren einer elektromagnetischen Strahlung (49; 56), die mindestens einen Fotodetektor (Pix; Pix1) aufweist, der eine organische Diode (D), die sich von einer Leuchtdiode unterscheidet, und eine organische Fotodiode (PH) aufweist, die in einem gleichen Stapel (30) von Halbleiterschichten (32, 34, 36) gebildet ist, wobei die organische Fotodiode die genannte Strahlung empfängt, wobei der Fotodetektor ferner mindestens einen Schirm (44) aufweist, der für die genannte Strahlung opak bzw. undurchlässig ist und den der Diode entsprechenden Teil des Stapels abschirmt.

2. Die Vorrichtung zum Detektieren nach Anspruch 1, wobei die Anode der Diode (D) mit der Anode der Photodiode (PH) verbunden ist oder wobei die Kathode der Diode mit der Kathode der Photodiode verbunden ist.

3. Die Vorrichtung zum Detektieren nach Anspruch 1 oder 2, die Folgendes aufweist: einen Träger (20), einen ersten leitenden Abschnitt (26), der sich über den Träger erstreckt, und einen zweiten leitenden Abschnitt (28), der sich über den Träger erstreckt, wobei der Stapel (30) den ersten leitenden Abschnitt zumindest teilweise und den zweiten leitenden Abschnitt zumindest teilweise bedeckt, wobei der Mindestabstand zwischen dem ersten leitenden Abschnitt und dem zweiten leitenden Abschnitt größer als 10 nm ist.

4. Die Vorrichtung zum Detektieren nach Anspruch 3, wobei sich der opake Schirm (44) auf der Seite des Trägers (20) befindet, die dem ersten und zweiten leitenden Abschnitt (26, 28) gegenüberliegt.

5. Die Vorrichtung zum Detektieren nach Anspruch 3, wobei der erste leitende Abschnitt (26) für die Strahlung zumindest teilweise transparent ist und wobei der zweite leitende Abschnitt (28) für die Strahlung opak bzw. undurchsichtig ist.

6. Die Vorrichtung zum Detektieren nach Anspruch 3, die ferner eine den Stapel (30) bedeckende Isolierschicht (38) aufweist, wobei der opake Schirm (44) auf der Isolierschicht, und zwar auf der dem Stapel gegenüberliegenden Seite der Isolierschicht angeordnet ist.

7. Die Vorrichtung zum Detektieren nach Anspruch 6, die ferner ein leitendes Element (40) aufweist, das sich über die Isolierschicht (38) und durch die Isolierschicht hindurch erstreckt, wobei das leitende Element (40) in Kontakt mit dem ersten leitenden Abschnitt (26) oder mit dem zweiten leitenden Abschnitt (28) steht, wobei das leitende Element (40) ferner den opaken Schirm bildet.

8. Die Vorrichtung zum Detektieren nach einem der Ansprüche 1 bis 7, die eine Anordnung von Photodetektoren (Pix) aufweist, die in Zeilen und Spalten aufgeteilt bzw. verteilt sind.

9. Die Vorrichtung zum Detektieren nach einem der Ansprüche 1 bis 8, wobei der Stapel (30) mindestens erste, zweite und dritte Halbleiterschichten aufweist, wobei die zweite Halbleiterschicht (34) zwischen der ersten Halbleiterschicht (32) und der dritten Halbleiterschicht (36) angeordnet ist und mit der ersten Halbleiterschicht und der dritten Halbleiterschicht in Kontakt steht, wobei die zweite jene Schicht ist, in der der größte Anteil der von der Fotodiode (PH) empfangenen Strahlung eingefangen wird.

10. Die Vorrichtung zum Detektieren nach Anspruch 9 rückbezogen auf Anspruch 3, wobei die erste Halbleiterschicht (32) mit dem ersten leitenden Abschnitt (26) und mit dem zweiten leitenden Abschnitt (28) in Kontakt steht.

11. Die Vorrichtung zum Detektieren nach Anspruch 9 oder 10, wobei die erste Halbleiterschicht (32) und/oder die dritte Halbleiterschicht (36) aus einem Material hergestellt ist bzw. sind, das ausgewählt ist aus der Gruppe, die Folgendes aufweist:
ein Metalloxid, insbesondere ein Titanoxid oder ein Zinkoxid;
ein molekulares Wirts-/Dotierstoffsystem;
ein leitfähiges oder dotiertes Halbleiterpolymer, zum Beispiel das Polymer PEDOT:Tosylat, das eine Mischung aus Poly(3,4)-Ethylendioxythiophen und Tosylat ist;
ein Carbonat, zum Beispiel CsCO3;
ein Polyelektrolyt, zum Beispiel aus Poly[9,9-bis(3'-(N,N-dimethylamino)propyl)-2,7-fluoren-alt-2,7-(9,9-dioctyfluoren)] (PFN), aus Poly[3-(6-trimethylammoniumhexyl]thiophen (P3TMAHT) oder aus Poly[9,9-bis(2-ethylhexyl)fluoren]-b-poly[3-(6-trimethyl-ammoniumhexyl]thiophen (PF2/6-b-P3TMAHT);
ein Polymer aus Polyethylenimin (PEI) oder ein Polymer vom Polymer aus ethoxyliertem Polyethylenimin (PEIE), propoxyliertem Polyethylenimin und/oder butoxyliertem Polyethylenimin; und
ein Gemisch aus zwei oder mehr als zwei dieser Materialien.

## Claims

1. A device (10) for detecting an electromagnetic radiation (49; 56) comprising at least one photodetector (Pix; Pix1) comprising an organic diode (D), different from a light-emitting diode, and an organic photodiode (PH) formed in a same stack (30) of semiconductor layers (32, 34, 36), the organic photodiode receiving said radiation, the photodetector further comprising at least one screen (44) opaque to said radiation and screening the portion of the stack corresponding to the diode.

2. The detection device of claim 1, wherein the anode of the diode (D) is connected to the anode of the photodiode (PH) or the cathode of the diode is connected to the cathode of the photodiode.

3. The detection device of claim 1 or 2, comprising a support (20), a first conductive portion (26) extending over the support and a second conductive portion (28) extending over the support, the stack (30) at least partially covering the first conductive portion and at least partially covering the second conductive portion, the minimum distance between the first conductive portion and the second conductive portion being greater than 10 nm.

4. The detection device of claim 3, wherein the opaque screen (44) is located on the side of the support (20) opposite to the first and second conductive portions (26, 28).

5. The detection device of claim 3, wherein the first conductive portion (26) is at least partially transparent to the radiation and the second conductive portion (28) is opaque to the radiation.

6. The detection device of claim 3, further comprising an insulating layer (38) covering the stack (30), the opaque screen (44) being located on the insulating layer, on the side of the insulating layer opposite to the stack.

7. The detection device of claim 6, further comprising a conductive element (40) extending over the insulating layer (38) and through the insulating layer, the conductive element (40) being in contact with the first conductive portion (26) or with the second conductive portion (28), the conductive element (40) further forming the opaque screen.

8. The detection device of any of claims 1 to 7, comprising an array of photodetectors (Pix) distributed in rows and in columns.

9. The detection device of any of claims 1 to 8, wherein the stack (30) comprises at least first, second, and third semiconductor layers, the second semiconductor layer (34) being interposed between the first semiconductor layer (32) and the third semiconductor layer (36) and being in contact with the first semiconductor layer and with the third semiconductor layer, the second semiconductor layer being the layer having most of the radiation received by the photodiode (PH) captured therein.

10. The detection device of claim 9 and of claim 3, wherein the first semiconductor layer (32) is in contact with the first conductive portion (26) and with the second conductive portion (28).

11. The detection device of claim 9 or 10, wherein the first semiconductor layer (32) and/or the third semiconductor layer (36) is made of a material selected from the group comprising:
a metal oxide, particularly a titanium oxide or a zinc oxide;
a molecular host/dopant system;
a conductive or doped semiconductor polymer, for example, the PEDOT:Tosylate polymer which is a mixture of poly(3,4)-ethylenedioxythiophene and of tosylate;
a carbonate, for example CsCO3;
a polyelectrolyte, for example, poly[9,9-bis(3'-(N,N-dimethylamino)propyl)-2,7-fluorene-alt-2,7-(9,9-dioctyfluorene)] (PFN), poly[3-(6-trimethylammoniumhexyl] thiophene (P3TMAHT) or poly[9,9-bis(2-ethylhexyl)fluorene]-b-poly[3-(6-trimethylammoniumhexyl] thiophene (PF2/6-b-P3TMAHT);
a polyethyleneimine (PEI) polymer or a polyethyleneimine ethoxylated (PEIE), propoxylated, and/or butoxylated polymer; and
a mixture of two or more of these materials.
